# EUROPEAN PATENT SPECIFICATION

(11) **EP 4 369 401 B1**
(45) Date of publication and mention of the grant of the patent: **09.12.2026**
(21) Application number: 23203845.5
(22) Date of filing: 16.10.2023
(51) Int. Cl.: H10D 89/60

(54) **ESD PROTECTION CIRCUIT FOR NEGATIVE VOLTAGE OPERATION**
ESD-SCHUTZSCHALTUNG FÜR NEGATIVE SPANNUNGSVERSORGUNG
CIRCUIT DE PROTECTION CONTRE LES DÉCHARGES ÉLECTROSTATIQUES POUR FONCTIONNEMENT À TENSION NÉGATIVE

(30) Priority: 09.11.2022 US 202263382892 P; 27.09.2023 US 202318373288
(43) Date of publication of application: 15.05.2024
(73) Proprietor: MediaTek Inc., Hsin-Chu 300 (TW)
(72) Inventor: CHEN, Ming-Chun, 30078 Hsinchu City (TW); HUANG, Bo-Shih, 30078 Hsinchu City (TW)
(74) Representative: Haseltine Lake Kempner LLP

(56) References cited:
- US-A- 5 637 900
- US-A1- 2004 212 936
- US-A1- 2006 152 868
- LAI DA-WEI ET AL: "Bidirectional ESD Protection Device Using PNP With pMOS-Controlled Nwell Bias", IEEE ELECTRON DEVICE LETTERS, IEEE, USA, vol. 39, no. 3, 1 March 2018 (2018-03-01), pages 331 - 334, XP011678765, ISSN: 0741-3106, [retrieved on 20180226], DOI: 10.1109/LED.2018.2795253

## Description

This application claims the benefit of U.S. Provisional Application No. 63/382,892, filed on November 9th, 2022.

### Background

In order to protect internal circuits of a die from being damaged by electrostatic discharge (ESD), one or more ESD protection circuits are designed within the die to pass a human body model (HBM) and charged device model (CDM) of ESD specifications. In the conventional art, one or more diodes serving as the ESD protection circuit are connected between an input/output (I/O) pin and a ground voltage, and these diodes absorb the short-duration voltage pulses during the ESD strike, that is high peak currents from the ESD strike flow to the ground through the diodes and limit the ESD strike voltages from damaging the internal circuits.

However, when the ESD protection circuit having diodes is used for the I/O pin having negative voltage, a parasitic diode may be formed between the I/O pin and the ground voltage so that a junction forward leakage current is generated. To solve this problem, the conventional art uses a deep N-well isolation technique to isolate the P-type diffusion of the first diode and the N-type diffusion of the last diode. However, the deep N-well process and mask will increase the manufacturing costs.
US 5,637,900 discloses an ESD protection circuit fully protecting the input stage of CMOS integrated circuits from four different ESD stress modes by providing four different ESD direct discharging paths. The ESD protection circuit has a primary ESD protection circuit, which has a first and a second thick-oxide MOS devices, and a secondary ESD protection circuit which has a resistor, a first and a second thin-oxide MOS devices. The resistor is connected between the primary and secondary ESD protection circuits. The primary and secondary ESD protection circuits each provide two ESD discharge paths from the input pad, and from the input of the internal circuits to be protected, to VDD and VSS voltage supply buses. The inventive ESD protection circuit also has merged latchup guard rings and protects against large ESDs, while occupying only a small layout area. Furthermore, the inventive ESD protection circuit clamps the voltage level of the input signal between 5.5 to -1 volts, the voltages applied to the thin-oxide CMOS input stage of the internal circuits.
US 2004/0212936 discloses a CMOS electrostatic discharge (ESD) protection circuit in a substrate of a first conductivity type, in which a discharge circuit having an MOS transistor in the substrate is operable to discharge the ESD pulse to ground. A drive circuit has a plurality of forward-biased diodes in separate wells of the opposite conductivity type, connected as a string in forward direction. During an ESD event, the diode string uses a portion of the ESD pulse's voltage to enter a high-conductance, conductivity-modulated state, and to provide a large substrate current, and consequently a substrate voltage drop, to turn-on the MOS transistor so that it will ground the ESD pulse.
US 2006/0152868 relates to an ESD protection with ability to enhance trigger-on speed of a low voltage Triggered PNP (LVTPNP) unit for protecting internal circuits of an integrated circuit from attack of an ESD stress. The ESD protection unit incorporates either detection circuit or power clamp circuit to efficiently trigger on a trigger node as a heavily doped region of LVTPNP devices among an I/O pad, a VDD pin and a VSS pin. As soon as the trigger node of each LVTPNP device receives a trigger signal from either the ESD detection circuit or power clamp circuit, the threshold voltage of the LVTPNP devices are capable of being therefore reduced to enhance trigger-on speed of the LVTPNP devices that discharge ESD current.

### Summary

It is therefore an objective of the present invention to provide a ESD protection circuit for the I/O pin having a negative voltage, which can avoid leakage current without using deep N-well process, to solve the above-mentioned problems.

The present invention is defined by the appended claims.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a chip according to a first example not forming part of the claimed invention.
FIG. 2 is a diagram illustrating a chip according to a second example not forming part of the claimed invention.
FIG. 3 is a diagram illustrating a chip according to an embodiment of the present invention.
FIG. 4 is a diagram illustrating a chip according to an embodiment of the present invention.
FIG. 5 is a diagram illustrating the ESD detection circuit, the control circuit and part of the internal circuit according to one embodiment of the present invention.
FIG. 6 is a diagram illustrating a chip according to example not forming part of the claimed invention.
FIG. 7 is a diagram illustrating a chip according to example not forming part of the claimed invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

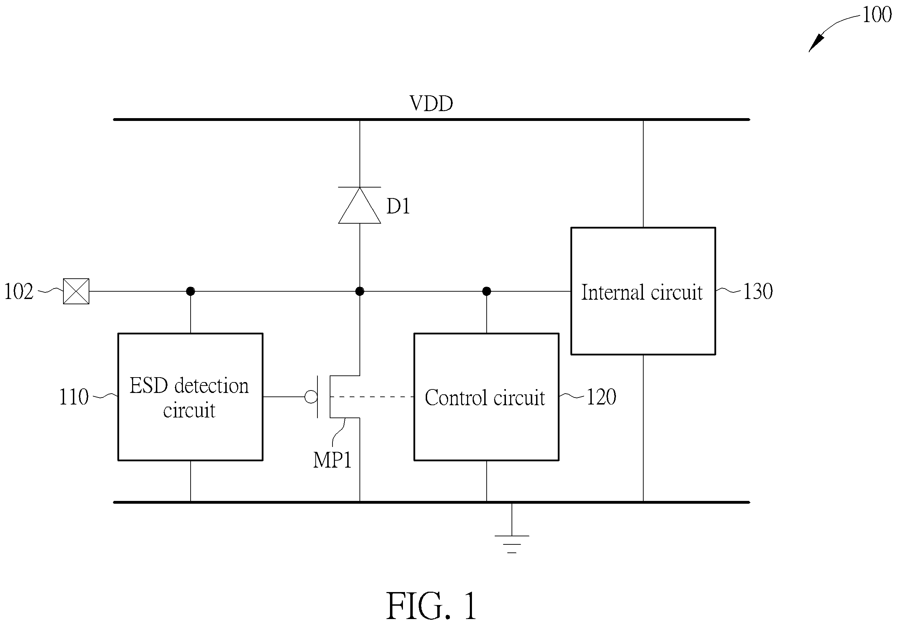

FIG. 1 is a diagram illustrating a chip 100 according to one embodiment of the present invention. As shown in FIG. 1, the chip 100 comprises an I/O pin 102, an ESD detection circuit 110, a control circuit 120, an internal circuit 130, and an ESD protection circuit comprising a P-type transistor MP1 and at least one diode D1, wherein the I/O pin 102 is used to receive a negative voltage from a device external to the chip 100, and the negative voltage is lower than a ground voltage, for example, the negative voltage may be -1V.

In the embodiment shown in FIG. 1, the P-type transistor MP1 and the diode D1 serves as the ESD protection circuit to absorb the short-duration voltage pulses during the ESD strike, wherein a drain electrode of the P-type transistor MP1 is directly connected to the I/O pin 102 without passing through any other circuit element, and a source electrode of the P-type transistor MP1 is coupled to the ground voltage, that is, there may or may not be other circuit element(s) between the source electrode and the ground voltage; an anode of the diode D1 is directly connected to the I/O pin 102 without passing through any other circuit element, and a cathode of the diode D1 is coupled to a supply voltage VDD, that is, there may or may not be other circuit element (s) between the cathode of the diode D1 and the supply voltage VDD. The ESD detection circuit 110 is configured to detect a voltage level of the I/O pin 102 to determine if enabling the P-type transistor MP1, that is, if the I/O pin 102 suffers ESD strikes, the ESD detection circuit 110 generates a control signal to enable the P-type transistor MP1 to form a current path; and the P-type transistor MP1 is disabled when the I/O pin 102 has the normal negative voltage. In addition, a bulk of the P-type transistor MP1 is connected to its source electrode or a bias voltage provided by the control circuit 120, wherein the control circuit 120 is an optional device that can be removed from the chip 100.

In this embodiment, the I/O pin 102 only connects to the anode of the diode D1 and the drain electrode of the P-type transistor MP1, without connecting to the cathode of any diode or source/drain electrode of any N-type transistor. Therefore, since the I/O pin 102 only connects to the P-type doping/diffusion (e.g., boron, aluminum, gallium or any other P-type dopant) of the semiconductor device, without directly connecting to any N-type doping/diffusion (e.g., phosphorus, arsenic or any other N-type dopant), a junction forward leakage current from the ground to the I/O pin 102 will not be generated, so that a power consumption of the chip 100 can be improved. In addition, because there is no need to use the deep N-well isolation technique in the ESD protection circuit, the manufacturing cost will not increase.

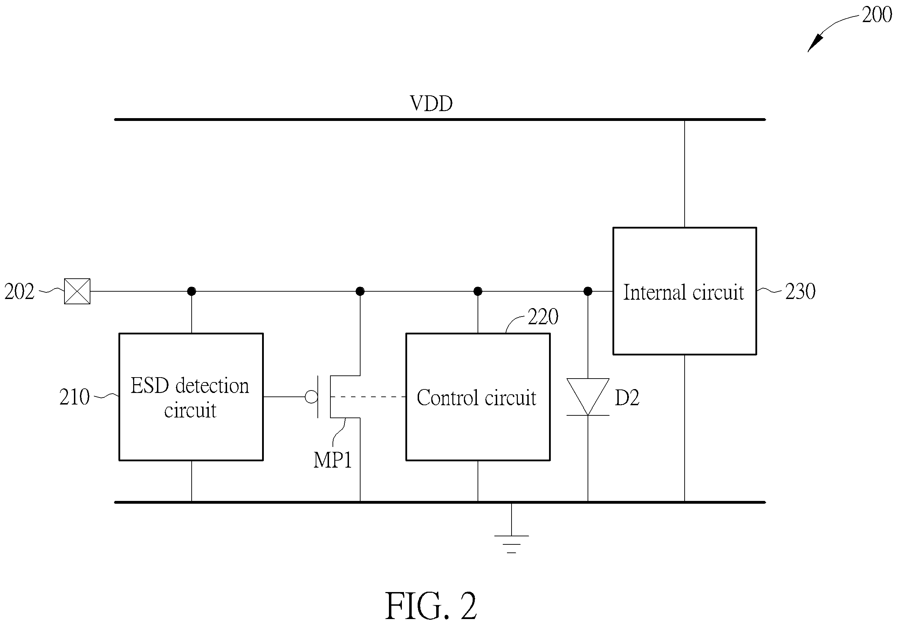

FIG. 2 is a diagram illustrating a chip 200 according to one embodiment of the present invention. As shown in FIG. 2, the chip 200 comprises an I/O pin 202, an ESD detection circuit 210, a control circuit 220, an internal circuit 230, and an ESD protection circuit comprising a P-type transistor MP1 and at least one diode D2, wherein the I/O pin 202 is used to receive a negative voltage from a device external to the chip 200, and the negative voltage is lower than the ground voltage.

In the embodiment shown in FIG. 2, the P-type transistor MP1 and the diode D2 serves as the ESD protection circuit to absorb the short-duration voltage pulses during the ESD strike, wherein a drain electrode of the P-type transistor MP1 is directly connected to the I/O pin 202 without passing through any other circuit element, and a source electrode of the P-type transistor MP1 is coupled to the ground voltage, that is, there may or may not be other circuit element(s) between the source electrode and the ground voltage; an anode of the diode D2 is directly connected to the I/O pin 202 without passing through any other circuit element, and a cathode of the diode D2 is coupled to the ground voltage , that is, there may or may not be other circuit element (s) between the cathode of the diode D2 and the ground voltage. The ESD detection circuit 210 is configured to detect a voltage level of the I/O pin 202 to determine if enabling the P-type transistor MP1, that is, if the I/O pin 202 suffers ESD strikes, the ESD detection circuit 210 enables the P-type transistor MP1 to form a current path; and the P-type transistor MP1 is disabled when the I/O pin 202 has the normal negative voltage. In addition, a bulk of the P-type transistor MP1 is connected to its source electrode or a bias voltage provided by the control circuit 220, wherein the control circuit 220 is an optional device that can be removed from the chip 200.

In this embodiment, the I/O pin 202 only connects to the anode of the diode D2 and the drain electrode of the P-type transistor MP1, without connecting to the cathode of any diode or source/drain electrode of any N-type transistor. Therefore, since the I/O pin 202 only connects to the P-type doping/diffusion of the semiconductor device, without directly connecting to any N-type doping/diffusion, a junction forward leakage current from the ground to the I/O pin 202 will not be generated, so that a power consumption of the chip 200 can be improved. In addition, because there is no need to use the deep N-well isolation technique in the ESD protection circuit, the manufacturing cost will not increase.

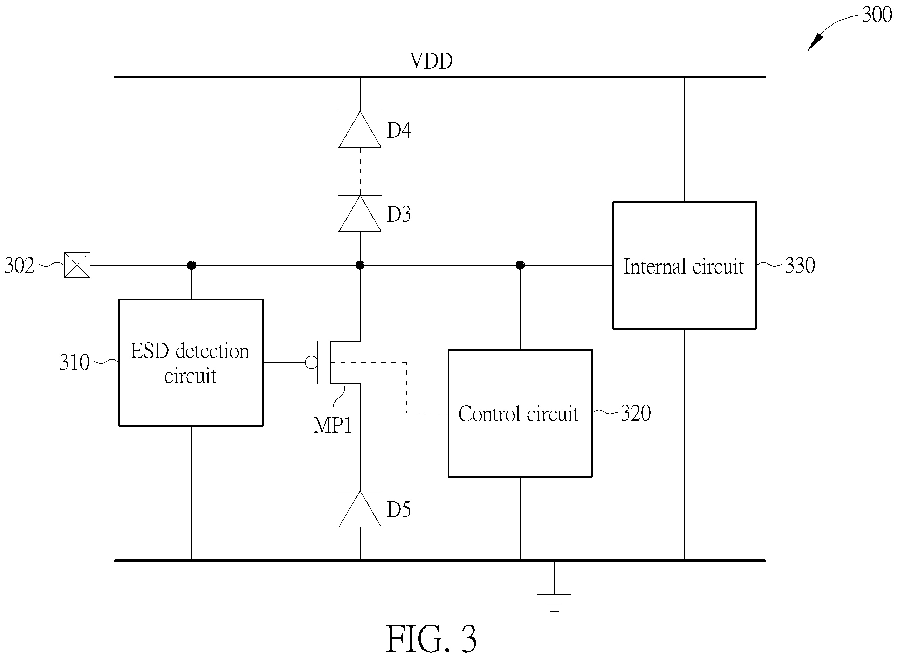

FIG. 3 is a diagram illustrating a chip 300 according to one embodiment of the present invention. As shown in FIG. 3, the chip 300 comprises an I/O pin 302, an ESD detection circuit 310, a control circuit 320, an internal circuit 330, and an ESD protection circuit comprising a P-type transistor MP1 and a plurality of diodes such as D3 - D5, wherein the I/O pin 302 is used to receive a negative voltage from a device external to the chip 300, and the negative voltage is lower than the ground voltage.

In the embodiment shown in FIG. 3, the P-type transistor MP1 and the diodes D3 - D5 serves as the ESD protection circuit to absorb the short-duration voltage pulses during the ESD strike, wherein a drain electrode of the P-type transistor MP1 is directly connected to the I/O pin 302 without passing through any other circuit element, and a source electrode of the P-type transistor MP1 is coupled to the ground voltage via the diode D5. In this embodiment, an anode of the diode D5 is connected to the ground voltage, a cathode of the diode D5 is coupled to the source electrode of the P-type transistor, wherein there may or may not be other circuit element (s) between the source electrode and the diode D5. The diodes D3 and D4 form a diode string, wherein an anode of the diode D3 is directly connected to the I/O pin 302 without passing through any other circuit element, and a cathode of the diode D4 is coupled to a supply voltage VDD, and there may or may not be other diode (s) between the diodes D3 and D4. The ESD detection circuit 310 is configured to detect a voltage level of the I/O pin 302 to determine if enabling the P-type transistor MP1, that is, if the I/O pin 302 suffers ESD strikes, the ESD detection circuit 310 enables the P-type transistor MP1 to form a current path; and the P-type transistor MP1 is disabled when the I/O pin 302 has the normal negative voltage. In addition, a bulk of the P-type transistor MP1 is connected to its source electrode or a bias voltage provided by the control circuit 320, wherein the control circuit 320 is an optional device that can be removed from the chip 300.

In this embodiment, the I/O pin 302 only connects directly to the anode of the diode D3 and the drain electrode of the P-type transistor MP1, without connecting directly to the cathode of any diode or source/drain electrode of any N-type transistor. Therefore, since the I/O pin 302 only connects to the P-type doping/diffusion of the semiconductor device, without directly connecting to any N-type doping/diffusion, a junction forward leakage current from the ground to the I/O pin 302 will not be generated, so that a power consumption of the chip 300 can be improved. In addition, because there is no need to use the deep N-well isolation technique in the ESD protection circuit, the manufacturing cost will not increase.

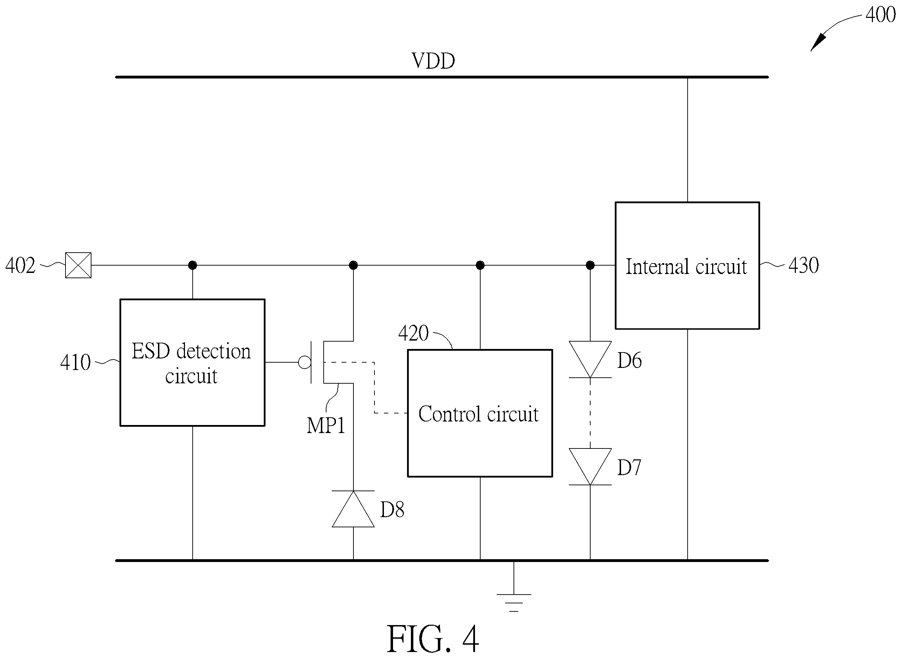

FIG. 4 is a diagram illustrating a chip 400 according to one embodiment of the present invention. As shown in FIG. 4, the chip 400 comprises an I/O pin 402, an ESD detection circuit 410, a control circuit 420, an internal circuit 430, and an ESD protection circuit comprising a P-type transistor MP1 and a plurality of diodes such as D6 - D8, wherein the I/O pin 402 is used to receive a negative voltage from a device external to the chip 400, and the negative voltage is lower than the ground voltage.

In the embodiment shown in FIG. 4, the P-type transistor MP1 and the diodes D6 - D8 serves as the ESD protection circuit to absorb the short-duration voltage pulses during the ESD strike, wherein a drain electrode of the P-type transistor MP1 is directly connected to the I/O pin 402 without passing through any other circuit element, and a source electrode of the P-type transistor MP1 is coupled to the ground voltage via the diode D8. In this embodiment, an anode of the diode D8 is connected to the ground voltage, a cathode of the diode D8 is coupled to the source electrode of the P-type transistor, wherein there may or may not be other circuit element (s) between the source electrode and the diode D8. The diodes D6 and D7 form a diode string, wherein an anode of the diode D6 is directly connected to the I/O pin 402 without passing through any other circuit element, and a cathode of the diode D7 is coupled to the ground voltage, and there may or may not be other diode (s) between the diodes D6 and D7. The ESD detection circuit 410 is configured to detect a voltage level of the I/O pin 402 to determine if enabling the P-type transistor MP1, that is, if the I/O pin 402 suffers ESD strikes, the ESD detection circuit 410 enables the P-type transistor MP1 to form a current path; and the P-type transistor MP1 is disabled when the I/O pin 402 has the normal negative voltage. In addition, a bulk of the P-type transistor MP1 is connected to its source electrode or a bias voltage provided by the control circuit 420, wherein the control circuit 420 is an optional device that can be removed from the chip 400.

In this embodiment, the I/O pin 402 only connects directly to the anode of the diode D6 and the drain electrode of the P-type transistor MP1, without connecting directly to the cathode of any diode or source/drain electrode of any N-type transistor. Therefore, since the I/O pin 402 only connects to the P-type doping/diffusion of the semiconductor device, without directly connecting to any N-type doping/diffusion, a junction forward leakage current from the ground to the I/O pin 402 will not be generated, so that a power consumption of the chip 400 can be improved. In addition, because there is no need to use the deep N-well isolation technique in the ESD protection circuit, the manufacturing cost will not increase.

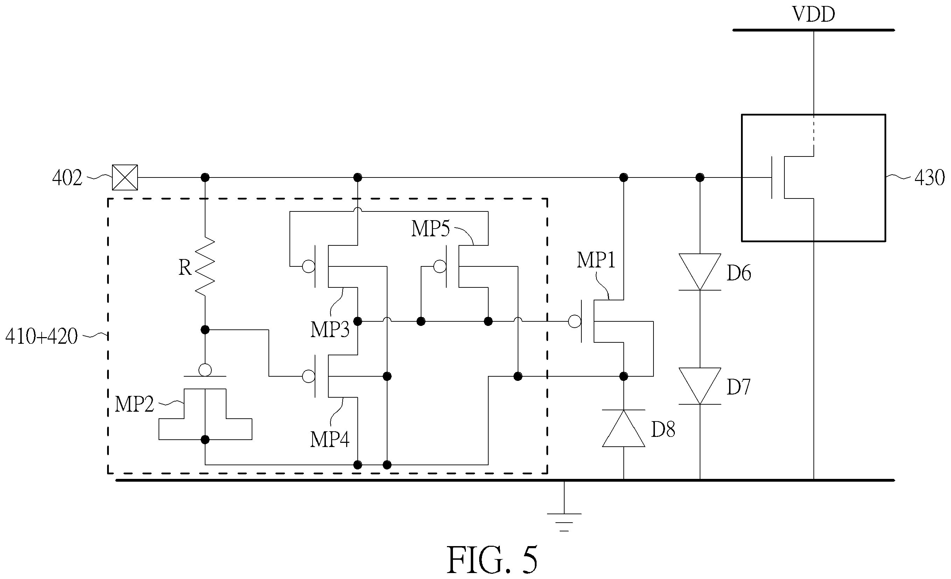

FIG. 5 is a diagram illustrating the ESD detection circuit 410, the control circuit 420 and part of the internal circuit 430 according to one embodiment of the present invention. As shown in FIG. 5, the ESD detection circuit 410 and the control circuit 420 comprise a resistor R, a P-type transistor MP2 serving as s metal-oxide-semiconductor capacitor and a plurality of P-type transistors MP3 - MP5, wherein a gate electrode of the P-type transistor MP2 is coupled to the I/O pin 402 via the resistor R, a drain electrode of the P-type transistor MP3 is directly connected to the I/O pin 402, a source electrode of the P-type transistor MP3 is coupled to a drain electrode of the P-type transistor MP4 and a gate electrode of the P-type transistor MP5, and a bulks of the P-type transistors MP1 - MP5 and source electrodes of the P-type transistors MP1, MP2 and MP4 are connected together. In addition, for the internal circuit 430, the I/O pin 402 is directly connected to a gate electrode of a transistor within the internal circuit 430.

In this embodiment shown in FIG. 5, for the ESD detection circuit 410, the control circuit 420 and the internal circuit 430, the I/O pin 402 only connects directly to the drain electrode of the P-type transistor and a gate electrode of the transistor, without connecting directly to the cathode of any diode or source/drain electrode of any N-type transistor.

It is noted that the embodiments of the ESD detection circuit 410, the control circuit 420 and part of the internal circuit 430 shown in FIG. 5 are for illustrative, not a limitation of the present invention, as long as the ESD detection circuit 410 can detect a voltage level of the I/O pin 402 to determine if enabling the P-type transistor MP1, the ESD detection circuit 410, the control circuit 420 and part of the internal circuit 430 can have any suitable designs.

In addition, the embodiments of the ESD detection circuit 410, the control circuit 420 and part of the internal circuit 430 shown in FIG. 5 can be used to implement the ESD detection circuit 110/210/310, the control circuit 120/220/320 and part of the internal circuit 130/230/330 shown in FIG. 1, FIG. 2 or FIG. 3.

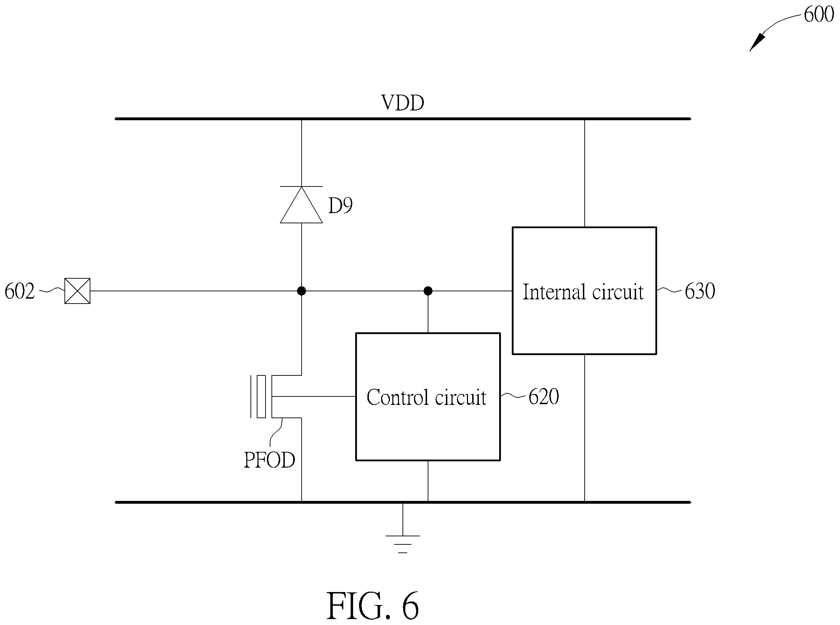

In the embodiment shown in FIG. 1 - FIG. 5, the P-type transistor MP1 and the ESD detection circuit 110/210/310/410 can be replaced by any other suitable P-type device capable of forming a current path during the ESD strike. Specifically, FIG. 6 is a diagram illustrating a chip 600 according to one embodiment of the present invention. As shown in FIG. 6, the chip 600 comprises an I/O pin 602, a control circuit 620, an internal circuit 630, and an ESD protection circuit comprising a P-type field-oxide device (PFOD) and at least one diode D9, wherein the I/O pin 602 is used to receive a negative voltage from a device external to the chip 600, and the negative voltage is lower than a ground voltage.

In the embodiment shown in FIG. 6, the PFOD and the diode D9 serves as the ESD protection circuit to absorb the short-duration voltage pulses during the ESD strike, wherein the PFOD is directly connected to the I/O pin 602 without passing through any other circuit element; an anode of the diode D9 is directly connected to the I/O pin 602 without passing through any other circuit element, and a cathode of the diode D9 is coupled to a supply voltage VDD, that is, there may or may not be other circuit element (s) between the cathode of the diode D9 and the supply voltage VDD. In addition, a bulk of the PFOD is connected to a bias voltage provided by the control circuit 620.

In other embodiments, the diode D2 shown in FIG. 2, the diodes D3 - D5 shown in FIG. 3, the diodes D6 - D8 shown in FIG. 4 can be applied to the chip 600. These alternative designs shall fall within the scope of the present invention.

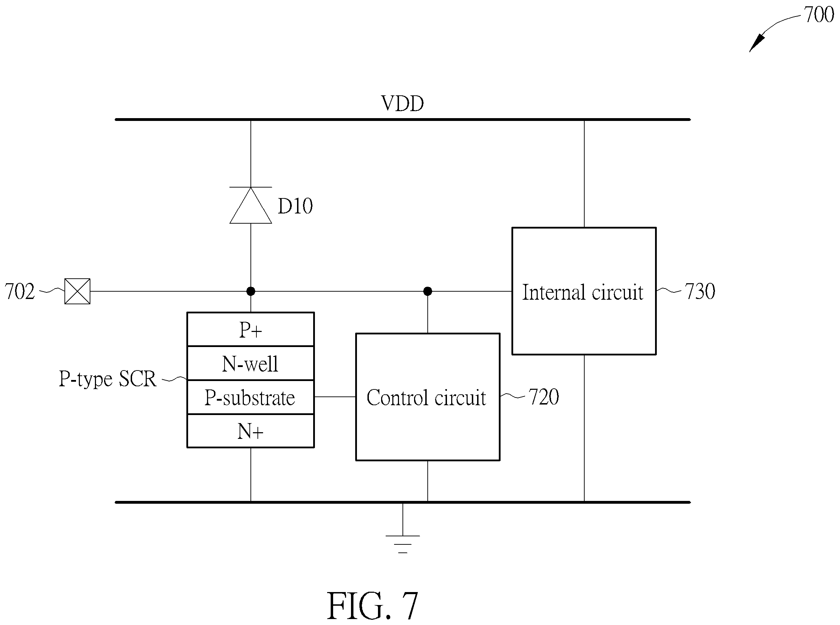

FIG. 7 is a diagram illustrating a chip 700 according to one embodiment of the present invention. As shown in FIG. 7, the chip 700 comprises an I/O pin 702, a control circuit 720, an internal circuit 730, and an ESD protection circuit comprising a P-type silicon controlled rectifier (SCR) and at least one diode D10, wherein the I/O pin 702 is used to receive a negative voltage from a device external to the chip 700, and the negative voltage is lower than a ground voltage.

In the embodiment shown in FIG. 7, the P-type SCR and the diode D10 serves as the ESD protection circuit to absorb the short-duration voltage pulses during the ESD strike. The P-type SCR comprises P+ diffusion, N-well, P-type substrate and N+ diffusion, wherein the P+ diffusion is directly connected to the I/O pin 702 without passing through any other circuit element, and the N+ diffusion is coupled to the ground voltage. An anode of the diode D10 is directly connected to the I/O pin 702 without passing through any other circuit element, and a cathode of the diode D10 is coupled to a supply voltage VDD, that is, there may or may not be other circuit element(s) between the cathode of the diode D10 and the supply voltage VDD. In addition, the P-type substrate is connected to a bias voltage provided by the control circuit 720.

In other embodiments, the diode D2 shown in FIG. 2, the diodes D3 - D5 shown in FIG. 3, the diodes D6 - D8 shown in FIG. 4 can be applied to the chip 700. These alternative designs shall fall within the scope of the present invention.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A chip (100, 200, 300, 400, 600, 700), comprising:
an input/output, I/O, pin;
an electrostatic discharge, ESD, protection circuit comprising a P-type device and a first diode, wherein the P-type device is coupled between the I/O pin (102, 202, 302, 402, 602, 702) and a ground voltage, and an anode of the first diode is directly connected to the I/O pin (102, 202, 302, 402, 602, 702);
wherein the I/O pin (102, 202, 302, 402, 602, 702) only directly connects to P-type doping/diffusion, instead of N-type doping/diffusion, of device (s) of the ESD protection circuit;
wherein a cathode of the first diode is coupled to a supply voltage; and the ESD protection circuit further comprises a second diode, wherein an anode of the second diode is coupled to the ground voltage, and a cathode of the second diode is coupled to the P-type device; or
a cathode of the first diode is coupled to the ground voltage; and the ESD protection circuit further comprises a second diode, wherein an anode of the second diode is coupled to the ground voltage, and a cathode of the second diode is coupled to the P-type device.

2. The chip (100, 200, 300, 400, 600, 700) of claim 1, wherein the P-type device is coupled between the I/O pin (102, 202, 302, 402, 602, 702) having a negative voltage and the ground voltage, and the negative voltage is lower than the ground voltage.

3. The chip (100, 200, 300, 400, 600, 700) of claim 1, wherein the P-type device is a P-type transistor, a P-type field-oxide device, PFOD, or a P-type silicon controlled rectifier, SCR.

4. The chip (100, 200, 300, 400, 600, 700) of claim 1, wherein the P-type device is a P-type transistor, a drain electrode of the P-type transistor is directly connected to the I/O pin (102, 202, 302, 402, 602, 702), a source electrode of the P-type transistor is coupled to the ground voltage; and the chip (100, 200, 300, 400, 600, 700) further comprises:
an ESD detection circuit (110, 210, 310, 410), configured to detect a voltage level of the I/O pin (102, 202, 302, 402, 602, 702) to determine if generating a control signal to enable the P-type transistor.

5. The chip (100, 200, 300, 400, 600, 700) of claim 4, wherein the ESD detection circuit (110, 210, 310, 410) does not comprise any device whose N-type doping/diffusion is directly connected to the I/O pin (102, 202, 302, 402, 602, 702).

6. The chip (100, 200, 300, 400, 600, 700) of claim 1, further comprising:
an internal circuit (130, 230, 330, 430, 630, 730) directly connected to the I/O pin (102, 202, 302, 402, 602, 702), wherein the internal circuit (130, 230, 330, 430, 630, 730) does not comprise any device whose N-type doping/diffusion is directly connected to the I/O pin (102, 202, 302, 402, 602, 702).

7. The chip (100, 200, 300, 400, 600, 700) of claim 1, wherein a cathode of the first diode is coupled to a supply voltage or the ground voltage.

## Patentansprüche

1. Chip (100, 200, 300, 400, 600, 700), umfassend:
einen Eingangs-/Ausgangs-Pin (I/O-Pin);
eine elektrostatische Entladungsschutzschaltung (ESD-Schutzschaltung), umfassend eine P-Typ-Vorrichtung und eine erste Diode, wobei die P-Typ-Vorrichtung zwischen dem I/O-Pin (102, 202, 302, 402, 602, 702) und einer Massespannung gekoppelt ist und eine Anode der ersten Diode direkt mit dem I/O-Pin (102, 202, 302, 402, 602, 702) verbunden ist;
wobei der I/O-Pin (102, 202, 302, 402, 602, 702) nur direkt mit der P-Dotierung/Diffusion und nicht mit der N-Dotierung/Diffusion der Vorrichtung(en) der ESD-Schutzschaltung verbunden ist;
wobei eine Kathode der ersten Diode mit einer Versorgungsspannung gekoppelt ist; und die ESD-Schutzschaltung ferner eine zweite Diode umfasst, wobei eine Anode der zweiten Diode mit der Massespannung gekoppelt ist und eine Kathode der zweiten Diode mit der P-Typ-Vorrichtung gekoppelt ist; oder
eine Kathode der ersten Diode mit der Massespannung gekoppelt ist; und die ESD-Schutzschaltung ferner eine zweite Diode umfasst, wobei eine Anode der zweiten Diode mit der Massespannung gekoppelt ist und eine Kathode der zweiten Diode mit der P-Typ-Vorrichtung gekoppelt ist.

2. Chip (100, 200, 300, 400, 600, 700) nach Anspruch 1, wobei die P-Typ-Vorrichtung zwischen dem I/O-Pin (102, 202, 302, 402, 602, 702) mit einer negativen Spannung und der Massespannung gekoppelt ist und die negative Spannung niedriger als die Massespannung ist.

3. Chip (100, 200, 300, 400, 600, 700) nach Anspruch 1, wobei die P-Typ-Vorrichtung ein P-Typ-Transistor, eine P-Typ-Feldoxidvorrichtung (PFOD) oder ein P-Typ-Silizium-gesteuerter Gleichrichter (SCR) ist.

4. Chip (100, 200, 300, 400, 600, 700) nach Anspruch 1, wobei die P-Typ-Vorrichtung ein P-Typ-Transistor ist, eine Drain-Elektrode des P-Typ-Transistors direkt mit dem I/O-Pin (102, 202, 302, 402, 602, 702) verbunden ist, eine Source-Elektrode des P-Typ-Transistors mit der Massespannung gekoppelt ist; und der Chip (100, 200, 300, 400, 600, 700) ferner umfasst:
eine ESD-Erkennungsschaltung (110, 210, 310, 410), die konfiguriert ist, um einen Spannungspegel des I/O-Pins (102, 202, 302, 402, 602, 702) zu erkennen, um zu bestimmen, ob ein Steuersignal zur Aktivierung des P-Typ-Transistors erzeugt werden soll.

5. Chip (100, 200, 300, 400, 600, 700) nach Anspruch 4, wobei die ESD-Erkennungsschaltung (110, 210, 310, 410) keine Vorrichtung umfasst, deren N-Dotierung/Diffusion direkt mit dem I/O-Pin (102, 202, 302, 402, 602, 702) verbunden ist.

6. Chip (100, 200, 300, 400, 600, 700) nach Anspruch 1, ferner umfassend:
eine interne Schaltung (130, 230, 330, 430, 630, 730), die direkt mit dem I/O-Pin (102, 202, 302, 402, 602, 702) verbunden ist, wobei die interne Schaltung (130, 230, 330, 430, 630, 730) keine Vorrichtung umfasst, deren N-Dotierung/Diffusion direkt mit dem I/O-Pin (102, 202, 302, 402, 602, 702) verbunden ist.

7. Chip (100, 200, 300, 400, 600, 700) nach Anspruch 1, wobei eine Kathode der ersten Diode mit einer Versorgungsspannung oder der Massespannung gekoppelt ist.

## Revendications

1. Puce (100, 200, 300, 400, 600, 700), comprenant :
une broche d'entrée/sortie, E/S ;
un circuit de protection contre les décharges électrostatiques, ESD, comprenant un dispositif de type P et une première diode, dans laquelle le dispositif de type P est couplé entre la broche E/S (102, 202, 302, 402, 602, 702) et une tension de masse, et une anode de la première diode est directement connectée à la broche E/S (102, 202, 302, 402, 602, 702) ;
dans laquelle la broche E/S (102, 202, 302, 402, 602, 702) se connecte directement uniquement au dopage/diffusion de type P, plutôt qu'à un dopage/une diffusion de type N, du circuit de protection contre les décharges électrostatiques ;
dans laquelle la cathode de la première diode est couplée à une tension d'alimentation ; et le circuit de protection contre les décharges électrostatiques comprend en outre une seconde diode, dans laquelle une anode de la seconde diode est couplée à la tension de masse, et une cathode de la seconde diode est couplée au dispositif de type P ; ou
une cathode de la première diode est couplée à la tension de masse ; et le circuit de protection contre les décharges électrostatiques comprend en outre une seconde diode, dans laquelle une anode de la seconde diode est couplée à la tension de masse, et une cathode de la seconde diode est couplée au dispositif de type P.

2. Puce (100, 200, 300, 400, 600, 700) selon la revendication 1, dans laquelle le dispositif de type P est couplé entre la broche E/S (102, 202, 302, 402, 602, 702) ayant une tension négative et la tension de masse, et la tension négative est inférieure à la tension de masse.

3. Puce (100, 200, 300, 400, 600, 700) selon la revendication 1, dans laquelle le dispositif de type P est un transistor de type P, un dispositif à oxyde de champ de type P, PFOD, ou un redresseur commandé au silicium de type P, SCR.

4. Puce (100, 200, 300, 400, 600, 700) selon la revendication 1, dans laquelle le dispositif de type P est un transistor de type P, l'électrode de drain du transistor de type P est directement connectée à la broche d'E/S (102, 202, 302, 402, 602, 702), une électrode de source du transistor de type P est couplée à la tension de masse ; et la puce (100, 200, 300, 400, 600, 700) comprend en outre :
un circuit de détection de décharges électrostatiques (110, 210, 310, 410), configuré pour détecter un niveau de tension de la broche E/S (102, 202, 302, 402, 602, 702) pour déterminer s'il faut générer un signal de commande pour activer le transistor de type P.

5. Puce (100, 200, 300, 400, 600, 700) selon la revendication 4, dans laquelle le circuit de détection de décharges électrostatiques (110, 210, 310, 410) ne comprend aucun dispositif dont le dopage/la diffusion de type N est directement connecté à la broche E/S (102, 202, 302, 402, 602, 702).

6. Puce (100, 200, 300, 400, 600, 700) selon la revendication 1, comprenant en outre :
un circuit interne (130, 230, 330, 430, 630, 730) directement connecté à la broche E/S (102, 202, 302, 402, 602, 702), dans laquelle le circuit interne (130, 230, 330, 430, 630, 730) ne comprend aucun dispositif dont le dopage/la diffusion de type N est directement connecté à la broche E/S (102, 202, 302, 402, 602, 702).

7. Puce (100, 200, 300, 400, 600, 700) selon la revendication 1, dans laquelle une cathode de la première diode est couplée à une tension d'alimentation ou à la tension de masse.
